# EUROPEAN PATENT APPLICATION

(11) **EP 2 757 695 A1**
(43) Date of publication of application: **23.07.2014**
(21) Application number: 13151774.0
(22) Date of filing: 18.01.2013
(51) Int. Cl.: H03M 7/46

(54) **Method and apparatus for encoding and decoding a data stream**

(71) Applicant: Johnson Controls Automotive Electronics GmbH, 75196 Remchingen (DE)
(72) Inventor: Kalaglarski, Damyan Georgiev, 1164 Sofia (BG)
(74) Representative: Finger, Catrin

(57) **Abstract**

The invention relates to a method for encoding and decoding a data stream (1, 3) according to a run length encoding scheme characterized in that repeatedly at most a first number of symbols is transferred from an input stream (1, 3) into an input packet buffer (2.1) and/or at most a second number of symbols is transferred from an output packet buffer (4.1) to an output stream (3, 5) and further characterized in that a status buffer (2.2, 4.2) is updated with every transfer operation. The invention further relates to an encoder (2) and an decoder (4) according to a run length encoding scheme, the encoder (2) and the decoder (4) comprising an input packet buffer (2.1) and an output packet buffer (4.1) of a predetermined capacity and further comprising a status buffer (2.2, 4.2).

## Description

The invention relates to a method and an apparatus for encoding and decoding a data stream.

From the state of the art, run length encoding methods are known that transform an input stream of data symbols into an output stream of data symbols and control symbols, wherein at least one subsequent repetition of a data symbol is removed and wherein the number of repetitions of a data symbol is encoded by a control symbol. Such methods are described for example in Robert Sedgewick: Algorithms, Addison-Wesley 1983, pages 284 to 286.

Also, methods that use statistical information on the frequency of symbols and/or groups of symbols for transforming such an input stream into an output stream are known from the state of the art. US 4 464 650 describes a method and an apparatus for compressing data signals and restoring the compressed data signals, wherein a compressor parses the input stream into segments where each segment comprises a prefix and the next symbol in the data stream following the prefix. The prefix of a segment is the longest match with a previously parsed segment of the data stream. The compressor constructs a search tree data base to effect the parsing and to generate a pointer for each segment pointing to the previous segment matching the prefix. The search tree comprises internal nodes including a root and external nodes denoted as leaves. The nodes are interconnected by branches representative of symbols of the alphabet. Each parsed segment of the input data is represented by a path from the root to a leaf. The tree is adaptively constructed from the input data such that as each new segment is parsed, one new internal node of the tree is created from a leaf and new leaves are defined, one for each symbol already encountered by the encoder plus an additional branch to represent all potential but unseen symbols. The compressor transmits a leaf pointer signal for each parsed segment representative of the prefix thereof and the suffixed symbol of the alphabet. A decompressor constructs an identical search tree in response to the received leaf pointers so as to reconstitute the original data stream.

It is an object of the present invention to provide an improved method and an improved apparatus for encoding and decoding a data stream

The object is achieved by a method according to claim 1 and by an apparatus according to claim 6.

Preferred embodiments of the invention are given in the dependent claims.

According to the invention, a method for processing a data stream, comprising an encoding method and a decoding method is provided. The encoding method comprises the steps of:
- reading a symbol sequence consisting of either a repetition of a data symbol, thus forming a repetitive type symbol sequence or consisting of at least one non-repetitive symbol, thus forming a non-repetitive type symbol sequence, from an unencoded input stream
- determining the symbol sequence length
- writing a control symbol encoding the symbol sequence length and a reduced symbol sequence with repetitions of a data symbol removed to an encoded output stream
   with these steps being iteratively repeated until the end of the unencoded input stream.

A data stream is sequence of data symbols and/or control symbols. A data stream may be an input stream or an output stream with respect to a method or an apparatus. A data stream may be an input stream with respect to a first method or apparatus and may simultaneously be an output stream with respect to a second method or apparatus. Also, a data stream may be an output stream with respect to a first method or apparatus and may simultaneously be an input stream with respect to a second method or apparatus. A data stream that does not comprise control symbols is referred to as unencoded or decoded stream. The term decoded stream is used for an output stream of a decoding method or apparatus.

A symbol sequence is a finite sequence of data symbols. A symbol sequence may be a sequence of identical data symbols. Such a symbol sequence is denoted as repetitive type symbol sequence, as for example AAA. A symbol sequence may alternatively be a sequence of data symbols where no subsequent symbols are identical. Then it is denoted as non-repetitive type symbol sequence, as for example CDEFG. A repetitive type symbol sequence comprises all subsequent repetitions of a data symbol. A non-repetitive type symbol sequence comprises all subsequent data symbols that are not immediately followed by a repetition. Thus, a repetitive type symbol sequence is always delimited by the beginning or the end of the unencoded input stream or by a non-repetitive type symbol sequence. Also, a non-repetitive type symbol sequence is always delimited by the beginning or the end of the unencoded input stream or by a repetitive type symbol sequence. As an example, from the unencoded input stream with the subsequent data symbols AAABBCDEFGGG four symbol sequences, namely the repetitive type symbol sequences AAA, BB and GGG and the non-repetitive type symbol sequence CDEF can be derived.

Repetitive type symbol sequences can be reduced by removing all repetitions of the data symbol. Thus the reduced symbol sequences A, B and G correspond to the repetitive type symbol sequences AAA, BB and GGG respectively. For non-repetitive type symbol sequences, the reduced symbol sequence equals the original non-repetitive type symbol sequence. Thus the reduced symbol sequence CDEF corresponds to the non-repetitive type symbol sequence CDEF.

The decoding method comprises the steps of:
- reading a control symbol encoding the symbol sequence length from an encoded input stream
- reading the reduced symbol sequence from an encoded input stream
- expanding the reduced symbol sequence to the symbol sequence by optionally appending repetitions of the data symbol in the reduced symbol sequence
- writing the symbol sequence to an decoded output stream, with these steps being iteratively repeated until the end of the encoded input stream.

According to the invention, within the encoding method repeatedly at most a first number of symbols is transferred from the respective input stream into an input packet buffer and within the decoding method repeatedly at most a second number of symbols is transferred from an output packet buffer to an output stream. According to the invention furthermore a status buffer is updated with every transfer operation.

Run length encoding and decoding methods known from the state of the art need to evaluate a stream segment of undetermined length in order to perform the encoding or decoding. If the unencoded input stream comprises the subsequent data symbols AAABBCDEFGGG, it would be sufficient for an encoding method known from the state of the art to evaluate at most four subsequent data symbols, as the maximum length of a symbol sequence is four. If, however, the unencoded input stream comprises the subsequent data symbols AAAAAAAAAAAA, or if the unencoded input stream comprises the subsequent data symbols ABABABABABAB, then the maximum length of a symbol sequence would be 12. Thus, encoding methods known from the state of the art must be prepared to read in an unencoded input stream in its entirety. Accordingly, decoding methods from the state of the art need to be prepared to write a decoded output stream in its entirety when expanding the respective reduced symbol sequences.

In the encoding method according to the invention, a predetermined finite number of data symbols is read from an unencoded input stream and stored in an input packet buffer. Any symbol sequences that are fully comprised in the input packet buffer are immediately processed as known from the state of the art. In other words: for such a fully comprised symbol sequence, its symbol sequence length is encoded in a control symbol. Then, the corresponding reduced symbol sequence is determined and both the control symbol encoding the type and the length of the symbol sequence as well as the reduced symbol sequence are written to an output packet buffer.

It is possible that a symbol sequence may not fit in its entirety into the input packet buffer. It is also possible that while a symbol sequence does fit into the input packet buffer, the end of such a symbol sequence cannot be determined since this would require the evaluation of the data symbol immediately following the symbol sequence, which may not be comprised in the input packet buffer.

According to the invention, such incomplete symbol sequences are processed as follows.

For an incomplete repetitive-type symbol sequence, the number of repetitions of a certain data symbol detected so far is determined. Specifically, with each repetition of the certain data symbol read from the input packet buffer, an input counter is incremented within a status buffer. Furthermore, the type of the symbol sequence being processed, i.e. the repetitive type, and the data symbol are stored in the status buffer.

When all symbols stored in the input packet buffer have been processed, the next chunk of data symbols is read from the unencoded input stream and transferred to the input packet buffer. If further repetitions of the certain data symbol are encountered, the input counter of the status buffer, indicating the preliminary symbol sequence length, is incremented accordingly until the end of the repetitive-type symbol sequence is detected or until the input packet buffer is processed completely. These steps are repeated until either the end of the repetitive type symbol sequence or the end of the unencoded input stream is detected. Thus, a repetitive type symbol sequence is correctly determined even if it stretches over a multiple of the input packet buffer size.

For incomplete non-repetitive type symbol sequences, all data symbols except for the last data symbol encountered in the input packet buffer are transferred to the output packet buffer. The number of non-repetitive data symbols encountered so far, i.e. the preliminary symbol sequence length, and the said last data symbol are stored in the status buffer. Also, the type of the symbol sequence being processed, i.e. the non-repetitive type, is stored in the status buffer. Then, the next chunk of data symbols is read from the unencoded input stream and transferred to the input packet buffer.

If a repetition of said data symbol is encountered at the beginning of the refreshed input packet buffer, the non-repetitive type symbol sequence is complete and the preliminary number of non-repetitive data symbols presents the symbol sequence length that is copied, together with the data symbols gathered in the output packet buffer, to the encoded output stream. If, on the contrary, the first data symbol at the beginning of the refreshed input packet buffer differs from the last data symbol stored in the status buffer, both said first data symbol from the input packet buffer and said last data symbol from the status buffer belong to the incomplete non-repetitive type symbol sequence. Both data symbols are written to the output packet buffer and the preliminary symbol sequence length stored in the status buffer is accordingly adapted. Then, further symbols in the input packet buffer are added to the non-repetitive type symbol sequence until a repetition of a data symbol is detected or until the input packet buffer is processed completely. These steps are repeated until either the end of the non-repetitive type symbol sequence or the end of the unencoded input stream is detected. Thus, a non-repetitive type symbol sequence is correctly determined even if it stretches over a multiple of the input packet buffer size.

It is possible that during the described steps of processing the input packet buffer the end of the output packet buffer is reached. Then, the output packet buffer is flushed to the encoded output stream and the processing resumes with the next write at the beginning of the flushed output packet buffer.

If, at the moment of flushing of the output packet buffer, there is an incomplete non-repetitive type symbol sequence, then the number count of the non-repetitive type symbols left from that sequence is stored to the status buffer, so that they can be copied to the output packet buffer after it is flushed and the next write starts at its beginning. If, at the moment of flushing of the output packet buffer, there is an incomplete repetitive sequence, the repetitive symbol of the sequence is stored to the status buffer, so that it can be copied to the output packet buffer after it is flushed and the next wire starts at its beginning. The control symbol of the repetitive sequence has already been put to the output packet buffer before flushing it, otherwise the sequence would not have been incomplete.

In the decoding method according to the invention, a predetermined finite number of data symbols and/or control symbols is read from an encoded input stream and stored in an input packet buffer. Any reduced symbol sequences that are fully comprised in the input packet buffer are immediately processed as known from the state of the art. In other words: for such a fully comprised reduced symbol sequence, the corresponding symbol sequence length is decoded from the control symbol retrieved from the input packet buffer. Then, the corresponding reduced symbol sequence is expanded and the resulting symbol sequence is written to an output packet buffer.

A reduced symbol sequence is expanded as follows. From decoding the control symbol that encodes the symbol sequence length and type, it is known whether the corresponding symbol sequence is of repetitive type or non-repetitive type.

For repetitive type symbol sequences, the data symbol following the control symbol encoding the symbol sequence length is repeatedly written to the output packet buffer, until the symbol sequence is restored in its original symbol sequence length.

For non-repetitive type symbol sequences, at least one data symbol following the control symbol encoding the symbol sequence length is written to the output packet buffer, wherein the number of data symbols written is equal to the decoded symbol sequence length. In other words: as the reduced symbol sequence is identical to the corresponding symbol sequence of a non-repetitive type, its entire length is copied into the output packet buffer.

It is possible that a reduced symbol sequence may not fit in its entirety into the input packet buffer. It is also possible, that a corresponding symbol sequence does not fit in its entirety into the output packet buffer.

According to the invention, such incomplete symbol sequences are processed as follows.

As a first step, the symbol sequence length and the symbol sequence type are decoded from a control symbol retrieved from the input packet buffer and are stored in the status buffer. Thus the status buffer indicates how many data symbols have to be written to the encoded output stream in order to complete the symbol sequence.

In a next step, at least one data symbol is retrieved from the input packet buffer. With each data symbol read from the input packet buffer, the status buffer is adapted as to indicate the number of data symbols that yet have to be read in order to completely process the reduced symbol sequence. For repetitive type symbol sequences, the first data symbol is replicated to build a symbol sequence with a length according to the symbol sequence length decoded from the control symbol. Said symbol sequence of replicated symbols is written to the output packet buffer. For non-repetitive type symbol sequences, data symbols read from the input packet buffer are written to the output packet buffer.

With each symbol written to the output packet buffer, the status buffer is updated so that at any point in time it indicates the type of the incomplete symbol sequence as well as the number of data symbols yet to be written to the encoded output stream.

If the end of the input packet buffer is reached prematurely before all data symbols of the reduced symbol sequence could be read, the input packet buffer is refilled with the next available symbols from the encoded input stream. Thus a reduced symbol sequence is decoded completely even if its length exceeds the capacity of the input packet buffer.

As an advantage, an encoding and decoding method according to the invention suffices with a fixed, predetermined size of both an input packet buffer and an output packet buffer. This is of particular advantage in operating environments with tight memory restrictions, particularly restrictions on contiguous memory. Furthermore, as buffers of a fixed size are being recycled by the encoding and decoding methods, the overhead caused by memory management as allocation and deallocation of dynamic heap memory, can be significantly decreased. Also, the methods according to the invention are available even on systems where no memory management unit (MMU) is provided, thus significantly reducing the software effort needed to implement such an encoding or decoding method.

Furthermore, since the allocation of dynamic heap memory can be avoided, the vulnerability for runtime errors such as exceptions caused by a lack of dynamic heap memory can be significantly reduced. Thus the availability and reliability of a system using such methods according to the invention is greatly improved, which is of particular importance for safety critical systems.

In an embodiment of the invention, the status buffer comprises data structures to store information on
- the type of the current symbol sequence
- the completion status of the current symbol sequence
- optionally, the number of data symbols of the current symbol sequence already read from an unencoded input stream
- optionally, the number of data symbols of the current symbol sequence to be read from an input stream or written to an output stream.

A symbol sequence type indicator indicates the type of the current symbol sequence, i.e. the symbol sequence being encoded into a reduced symbol sequence for the encoding method or the symbol sequence being decoded from a reduced symbol sequence for the decoding method.

A status indicator indicates if a symbol sequence is being processed. A symbol sequence is being processed in the case of the encoding method, if the length of the symbol sequence was not yet determined and/or if not all data symbols of the corresponding reduced symbol sequence have been written to the encoded output stream. A symbol sequence is being processed in the case of the decoding method, if not all data symbols of the corresponding reduced symbol sequence have been read from the encoded input stream and/or if not all data symbols of the symbol sequence have been written to the decoded output stream.

It is possible to store the status indicator and the symbol sequence type indicator in a shared data structure.

A symbol sequence length counter stores the number of data symbols determined so far as belonging to the symbol sequence being processed from an unencoded input stream. Said symbol sequence length counter is initialized with one when reading the first data symbol of a symbol sequence in an unencoded input stream. Said symbol sequence length counter is incremented with data symbol read from the unencoded input stream until the end of the symbol sequence is detected.

An input counter stores the number of data symbols that still have to be read from an encoded input stream in order to complete the reduced symbol sequence being processed. Said input counter is initialized with one in the case of a repetitive type symbol sequence. Said input counter is initialized with the symbol sequence length in the case of a non-repetitive type symbol sequence. With each data symbol read from an encoded input stream, the input counter is decremented.

An output counter stores the number of data symbols that still have to be written to an output stream in order to complete the symbol sequence being processed. Said output counter is initialized with the symbol sequence length in the case of the decoding method. Said output counter is initialized with one in the case of the encoding method for repetitive type symbol sequences. Said output counter is initialized with the symbol sequence length in the case of the encoding method for non-repetitive type symbol sequences. With each data symbol written to the output stream, said output counter is decremented.

According to this embodiment of an encoding method, the symbol sequence type indicator is set when the second data symbol of a symbol sequence was read. Then, it can be determined whether the symbol sequence is of repetitive or non-repetitive type. When the symbol sequence was completely read in from the unencoded input stream, the symbol sequence length counter equals the symbol sequence length. Then, the output counter is initialized as described previously.

According to this embodiment of a decoding method, the symbol sequence type indicator and the symbol sequence length indicator are set when the coding symbol was read for a symbol sequence. Then, the input counter and the output counter are initialized as described previously.

As an advantage of this embodiment, the status buffer is formed as a set of data structures that are readily available in various programming and operating environments. As an example, such indicators can be formed as global static variables when using the programming language C or C++. Then, these indicators are accessible from various functions and retain their values over distinct calls of those functions. Also, access to those data structures causes only a minor runtime overhead so that methods according to this embodiment operate in a fast and efficient way.

In an embodiment of the invention a data symbol is formed as a single byte or as an array of a predetermined number of bytes. This embodiment is particularly advantageous when transferring digitized image data across data buses in a distributed environment, wherein a pixel of a digitized image is represented by a plurality of bytes, as, for example, one byte for each of the colours red, green and blue. When transferring pixels in a row-wise or column-wise manner, adjacent pixels with the same colour information will form a repetitive-type symbol sequence. Thus, the encoding method will gain a substantial compression ratio.

In further practically relevant applications data such as characters, digitized values from sensors may be represented as a structure of a single or a plurality of bytes. Then a stream of signal values such as a stream of integer values or a stream of floating point values according to the IEEE 754 standard can be interpreted as a stream of data symbols.

Each data symbol is derived according to a presentation convention. As an advantage of this embodiment, the specifics of a certain presentation convention are irrelevant for the purpose of the encoding and decoding method proposed by the invention. Instead, for data symbols of a predetermined, fixed length it is sufficient to compare subsequent data symbols on a bit-by-bit, or even less elaborate, on a byte-by-byte basis in order to identify repetitive type and/or non-repetitive type symbol sequences. Thus this embodiment is particularly versatile and easy to implement.

According to an embodiment of the invention the symbol sequence length is encoded in a control symbol with a predetermined length, wherein the bit representation of the control symbol equals the symbol sequence length for repetitive type symbol sequences and wherein the bit representation of the control symbol equals the symbol sequence length plus a predetermined offset value for non-repetitive type symbol sequences. For example, a symbol sequence length between 1 and 127 can be encoded as a single byte value, wherein the bit patterns 0000001 to 01111111 denote symbol sequence lengths for non-repetitive type symbol sequences and wherein the bit patterns 10000001 to 11111111 denote symbol sequence lengths for repetitive type symbol sequences. In other words: for repetitive type symbol sequences an offset value of 128 is added to the symbol sequence length in order to form the control symbol. As a further example, since a symbol sequence length of 0 is per definition not possible, the representable numerical range of a single byte can be used even more efficiently when the bit patterns 00000000 to 01111111 denote symbol sequence lengths from 1 to 128 for a non-repetitive type symbol sequence, whereas the bit patterns 10000000 to 11111111 denote symbol sequence lengths from 1 to 128 for a repetitive type symbol sequence.

According to this embodiment of the invention both the information on the length and on the type of a symbol sequence is encoded in a single control symbol. Thus, the overhead, i.e. the extra amount of symbols needed in addition to the payload data symbols for encoding a data stream, is reduced. This results in a particularly low number of symbols in an encoded output stream, i.e. in an advantageously high compression ratio. As a further advantage, the type of the symbol sequence is determined very easily and efficiently. For example, a bitwise conjunction of the control symbol with the predetermined bit pattern 10000000 results in a Boolean value that is true for repetitive type symbol sequences and that is false for non-repetitive type symbol sequences. As most processors provide machine instructions that directly perform such bitwise conjunctions, the determination of the type of a symbol sequence and, for the same reason, the determination of the symbol sequence length can be implemented extremely fast and efficient, mostly within a single machine cycle.

According to a second aspect of the invention, an apparatus for encoding and/or decoding a data stream comprises a control unit iteratively performing the following steps for encoding a data stream:
- transferring a symbol sequence or parts thereof consisting of either a repetition of a data symbol, thus forming a repetitive type symbol sequence or consisting of at least one non-repetitive symbol, thus forming a non-repetitive type symbol sequence, from an unencoded input stream
- determining the symbol sequence length
- writing a control symbol encoding the symbol sequence length and a reduced symbol sequence with repetitions of a data symbol removed to an encoded output stream
   and/or iteratively performing the following steps for decoding a data stream:
- reading a control symbol encoding the symbol sequence length from an encoded input stream
- reading the reduced symbol sequence from an encoded input stream
- expanding the reduced symbol sequence to the symbol sequence by optionally appending repetitions of the data symbol in the reduced symbol sequence
- writing the symbol sequence to an decoded output stream The apparatus according to this second aspect of the invention further comprises an input packet buffer and/or an output packet buffer and a status buffer, each buffer with a predetermined capacity. At most a first number of symbols are transferred from an input stream into the input packet buffer and/or at most a second number of symbols are transferred from the output packet buffer to an output stream. The status buffer is adapted to be updated with each transfer of a symbol to the input packet buffer and/or from the output packet buffer.

The control unit can be adapted such that it controls the transfer of symbols to the input packet buffer and/or from the output packet buffer. It is also possible that said transfer of symbols is initiated by the control unit and, after this initialization, is performed by a buffer control unit in the kind of a Memory Management Unit (MMU).

During the iterative encoding and/or decoding procedure data symbols and/or control symbols are retrieved from the input packet buffer and/or transferred to the output packet buffer. As an advantage, the control unit can be simplified as to access predetermined memory arrays instead of variable memory addresses. Thus, for example, a less expensive processor can be used to build a control unit.

In an embodiment of the invention, the input packet buffer and/or the output packet buffer is formed as a ring buffer. A ring buffer, also known as circular buffer, is formed by a memory array comprising a plurality of memory cells that are mapped onto a linear address range, wherein the lowest memory address is regarded as successor to the highest memory address. A read pointer points to an address of said memory array. A write pointer points to an address of said memory array that is distinct from the address represented by the read pointer.

All addresses beyond the read pointer until the write pointer represent memory cells that are available for reading data symbols from the ring buffer, wherein a data symbol or a control symbol is stored in at least one memory cell. All addresses beyond the write pointer until the read pointer represent memory cells that are available for writing data symbols into the ring buffer.

As an example, data symbols retrieved from an unencoded input stream can be written into a ring buffer, using memory cells with addresses beyond the write pointer. Simultaneously, a predetermined number of memory cells beyond the read pointer of said ring buffer are being used as input packet buffer. Since these memory cells were previously filled with data symbols from the unencoded input stream, a transfer of data symbols from the input stream to the input packet buffer is unnecessary.

As a further example, data and/or control symbols generated by the encoding or decoding method according to the invention can be written into a ring buffer, using a predetermined number of memory cells with addresses beyond the write pointer as output packet buffer. The read pointer of said ring buffer points to the next symbol to be transferred to an encoded or decoded output stream.

As an advantage, this embodiment provides an efficient way to transfer data and/or control symbols between an unencoded or encoded input stream and an input packet buffer or between an output packet buffer and an encoded or decoded output stream. As a further advantage, this embodiment suffices with a limited amount of memory that is independent of the content of the unencoded or encoded input stream.

Further scope of applicability of the present invention will become apparent from the detailed description given hereinafter. However, it should be understood that the detailed description and specific examples, while indicating preferred embodiments of the invention, are given by way of illustration only, since various changes and modifications within the spirit and scope of the invention will become apparent to those skilled in the art from this detailed description.

### Brief Description of the Drawings

The present invention will become more fully understood from the detailed description given herein below and the accompanying drawings which are given by way of illustration only, and thus, are not limitive of the present invention, and wherein:
- Figure 1: schematically shows the encoding of an unencoded input stream and the decoding of an encoded input stream,
- Figure 2: schematically shows an unencoded input stream, the corresponding encoded output stream and the corresponding decoded output stream,
- Figure 3: shows a state diagram for the encoding method and
- Figure 4: shows a state diagram for the decoding method.

Corresponding parts are marked with the same reference symbols in all figures.

### Detailed Description of Preferred Embodiments

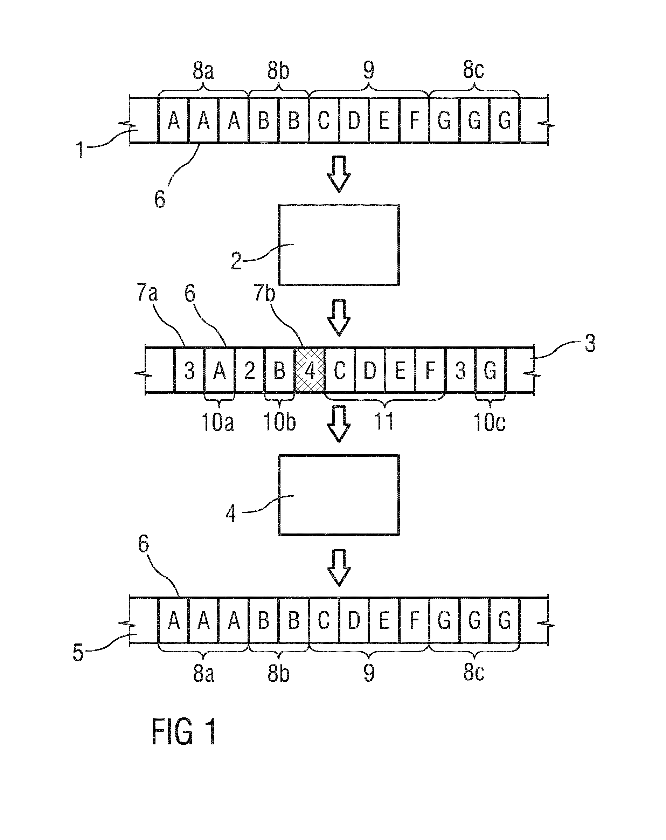

**Figure 1** shows the encoding of an unencoded input stream 1 according to a run length encoding (RLE) scheme known from the state of the art. The unencoded input stream 1 comprises a plurality of data symbols 6 that form a plurality of symbol sequences 8a, 8b, 8c, 9 of both repetitive and non-repetitive type. As an example, a single data symbol 6 may represent a character. It is also possible, that such a data symbol 6 represents a digitized sensor value such as a voltage, a velocity, acceleration or a temperature.

The unencoded input stream 1 is fed into an apparatus for encoding, known as encoder 2. The encoder 2 transforms each symbol sequence 8a, 8b, 8c, 9 of the unencoded input stream 1 into a reduced symbol sequence 10a, 10b, 10c, 11. For repetitive type symbol sequences 8a, 8b, 8c, all repetitions of a data symbol are removed. For non-repetitive type symbol sequences 9, the reduced symbol sequence 11 equals the symbol sequence 9. As an example, the repetitive type symbol sequences AAA, BB and GGG are transformed into reduced symbol sequences A, B and G, respectively. As a further example, the non-repetitive type symbol sequence CDEF is transformed into the reduced symbol sequence CDEF.

The concatenation of the reduced symbol sequences 10a, 10b, 11, 10c forms the encoded stream 3, which is an output stream with respect to the encoder 2, wherein each reduced symbol sequence 10a, 10b, 11, 10c is led by a control symbol 7a, 7b. The control symbol 7a, 7b indicates the length and the type of the symbol sequence that corresponds to the subsequent reduced symbol sequence. For example, the control symbol 7a, followed by the reduced symbol sequence 10a, indicates that the corresponding symbol sequence 8a is of repetitive type and comprises three instances of the data symbol 6 with the value A. As another example, the control symbol 7b, followed by the reduced symbol sequence 11, indicates that the corresponding symbol sequence 9 is of non-repetitive type and comprises the data symbols CDEF with a symbol sequence length of four.

The encoded output stream 3 thus formed as an output of the encoder 2 constitutes an encoded input stream 3 to an apparatus for decoding, known as decoder 4. From decoding the control symbol 7a, 7b, the decoder 4 may retrieve information on the type and the length of the subsequent reduced symbol sequence 10a, 10b, 11, 10c, comprising at least one data symbol 6. A reduced symbol sequence 10a, 10b, 10c following a control symbol 7a that indicates a repetitive type symbol sequence is expanded by appending repetitions of the single data symbol 6 until the indicated symbol sequence length is reached. A reduced symbol sequence 11 following a control symbol 7b that indicates a non-repetitive type is expanded by simply copying the data symbols 6 of the reduced symbol sequence 11. Thus, by concatenation of the expanded reduced symbol sequences 8a, 8b, 9, 8c, an decoded output stream 5 is formed that is equivalent to the unencoded input stream 1.

In many practically relevant applications, an unencoded input stream 1 regularly comprises multiple repetitions of a data symbol 6. Examples for such applications are data streams of sensor values or data streams of control parameters. In a stationary operation mode such sensor values or control parameters remain substantially constant over time. Then, the encoded output stream 3 generated by the encoder 2 suffices with a less number of symbols while retaining all information necessary for a decoder 4 to reconstruct the unencoded input stream 1. Therefore the encoded output stream 3 can be transmitted faster, or by a communication means with a reduced bandwidth.

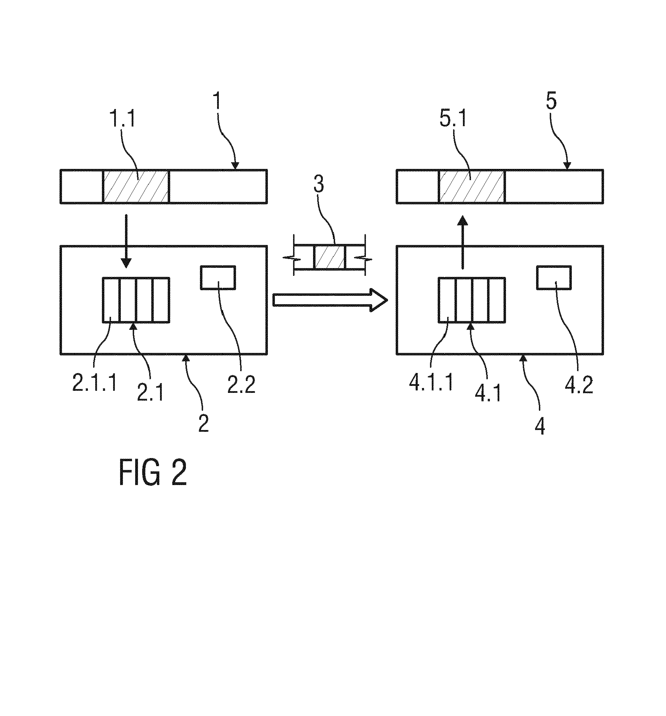

**Figure 2** shows the encoding and decoding of an unencoded input stream 1 according to the invention in more detail. A segment 1.1 of fixed length is transferred from the unencoded input stream 1 to the input packet buffer 2.1 of the encoder 2. The input packet buffer 2.1 has a predetermined capacity, i.e. it comprises a predetermined number of memory cells 2.1.1. A data symbol 6 that is part of the segment 1.1 is written into a single memory cell 2.1.1 or into a plurality of memory cells 2.1.1. As an example, a memory cell 2.1.1 may be formed as to store a single byte. Then, as a further example, a data symbol 6 representing a char data type of the programming language C is written into a single memory cell 2.1.1. Alternatively, a data symbol 6 representing a float data type of the programming language C is written into four memory cells 2.1.1.

The encoder 2 further comprises a status buffer 2.2 that is adapted to store information on the length and the type of a symbol sequence 8a, 8b, 8c, 9 that is fully or partly comprised in the segment 1.1 written into the input packet buffer 2.1. With each data symbol 6 read from the input packet buffer 2.1, the information in the status buffer 2.2 is updated. As an example, the status buffer 2.2 may comprise an input counter. At the beginning of each symbol sequence 8a, 8b, 8c, 9, said input counter is initialized with one. For each repetition of a data symbol 6 encountered in a repetitive type symbol sequence 8a, 8b, 8c within the segment 1.1 the input counter is incremented. Thus the value of the input counter equals the total number of instances of said data symbol 6 read so far.

For a symbol sequence that is fully comprised in the segment 1.1, the encoder 2 determines the reduced symbol sequence 10a, 10b, 11, 10c and transfers it to the encoded output stream 3. In particularity, the encoder 2 encodes the symbol sequence length, which is equal to the value of the input counter, and the symbol sequence type in a control symbol 7a, 7b followed by the data symbols 6 of the reduced symbol sequence 10a, 10b, 11, 10c. Then, the status buffer 2.2 is cleared and ready to take the type and length of the next symbol sequence 8a, 8b, 8c, 9.

If a symbol sequence 8a, 8b, 8c, 9 is not fully comprised in the segment 1.1 that is currently in the input packet buffer 2.1, a subsequent segment 1.1 is transferred from the unencoded input stream 1 to the input packet buffer 2.1, while the status buffer 2.2, indicating the type and the preliminary length of the symbol sequence 8a, 8b, 8c, 9 currently being processed, is retained. Then, the freshly written input packet buffer 2.1 is processed from its beginning until the end of the currently processed symbol sequence 8a, 8b, 8c, 9 is detected or until the entire input packet buffer 2.1 was processed. This procedure is repeated until the end, and thus the length, of the currently processed symbol sequence 8a, 8b, 8c, 9 was determined. Based on the information stored in the status buffer 2.2, the encoder 2 determines the reduced symbol sequence 10a, 10b, 11, 10c and transfers it via an output packet buffer not shown for the encoder 2 to the encoded output stream 3. Then, the status buffer 2.2 is cleared and ready to take the type and length of the next symbol sequence 8a, 8b, 8c, 9.

If the reduced symbol sequence 10a, 10b, 11, 10c does not fit in its entirety into the output packet buffer, it is split into a first part and at least one further part such that the first part fits into the output packet buffer. After transferring the first part to the encoded output stream 3, the further part is transferred into the output packet buffer and the status buffer denotes the number of symbols yet to be transferred to the encoded output stream 3. If necessary, the further part is again split into parts such that each part fits into the output packet buffer.

With respect to the decoder 4 the encoded output stream 3 of the encoder 2 is an encoded input stream 3. Similar to the encoding method, a predetermined number of symbols, i.e. both control symbols 7a, 7b and data symbols 6, read from the encoded input stream 3 are transferred to an input packet buffer not shown for the decoder 4. From decoding the control symbol 7a, 7b leading a reduced symbol sequence 10a, 10b, 11, 10c, the decoder determines the type and the length of the symbol sequence 8a, 8b, 8c, 9 to be expanded from the reduced symbol sequence 10a, 10b, 11, 10c. The status buffer 4.2 of the decoder 4 is initialized with this information. As an example, the status buffer 4.2 may comprise an output counter that is initialized with the symbol sequence length.

The decoder 4 further comprises an output packet buffer 4.1, comprising a plurality of memory cells 4.1.1. A reduced symbol sequence 10a, 10b, 11, 10c read from the encoded input stream 3 is expanded. Specifically, for a repetitive type symbol sequence 10a, 10b, 10c, the single data symbol 6 is repeated. For a non-repetitive type symbol sequence 11, the reduced symbol sequence 11 is taken. With each data symbol 6 of the expanded symbol sequence 8a, 8b, 8c, 9 written to the output packet buffer 4.1, the output counter in the status buffer 4.2 is decremented. Thus the output counter indicates the number of data symbols 6 that still have to be written in order to complete the currently processed reduced symbol sequence 10a, 10b, 11, 10c.

If the end of the output packet buffer 4.1 is reached before the symbol sequence 8a, 8b, 8c, 9 could be completed; the output packet buffer 4.1 is transferred to a segment 5.1 of a decoded output stream 5. Then, the output packet buffer 4.1 is filled from the beginning with data symbols 6 remaining for the current symbol sequence 8a, 8b, 8c, 9. When the output counter value reaches zero, the symbol sequence 8a, 8b, 8c, 9 is completed.

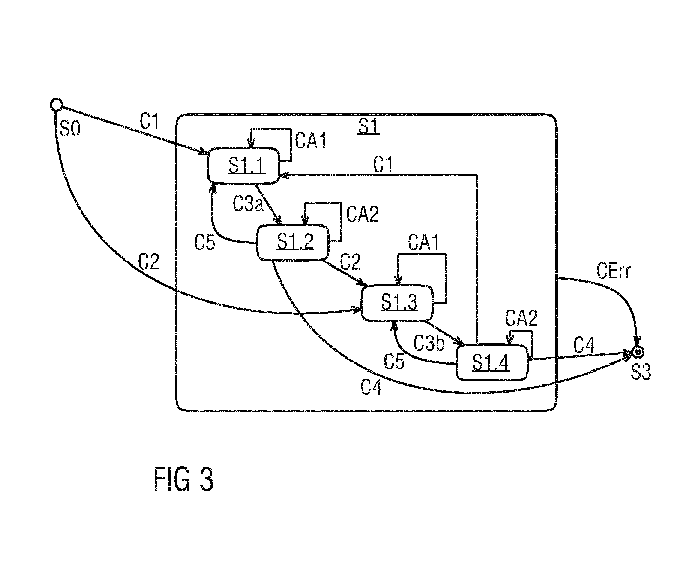

**Figure 3** shows a state diagram for the encoding method. The encoding process summarized in the encoding status S1 starts from a start state S0. Under the condition C1 that the first data symbol 6 of the unencoded input stream 1 is equal to the second data symbol 6, indicating a repetitive type symbol sequence 8a, 8b, 8c, the substate S1.1 is reached, wherein a repetitive type symbol sequence 8a, 8b, 8c is processed. In said substate S1.1, a predetermined number of data symbols 6 are read into the input packet buffer 2.1. Each data symbol 6 is compared with its successor. Once a differing subsequent data symbol 6 is encountered, indicating that the repetitive type symbol sequence 8a, 8b, 8c ends, condition C3a is fulfilled. Then substate S1.1 is left and substate S1.2 is entered, wherein the reduced symbol sequence 10a, 10b, 10c corresponding to the just completed repetitive type symbol sequence 8a, 8b, 8c is formed.

If the input packet buffer 2.1 was completely processed before the end of the repetitive type symbol sequence 8a, 8b, 8c was detected; the next segment 1.1 is read in from the unencoded input stream 1 into the input packet buffer 2.1. This is denoted by the condition/action type state transition CA1.

In the substate S1.2, the control symbol 7a, 7b encoding the length and type of the repetitive type symbol sequence 8a, 8b, 8c is written to the output packet buffer of the encoder, followed by the data symbol 6 of the reduced symbol sequence 10a, 10b, 10c. If said output packet buffer was completely filled, it is flushed to the encoded output stream 3, and the writing of the reduced symbol sequence 10a, 10b, 10c is resumed. This is indicated by the condition/action type state transition CA2.

Under the condition C2 that the first data symbol 6 of the unencoded input stream 1 is different from the second data symbol 6, indicating a non-repetitive type symbol sequence 9, the substate S1.3 is reached, wherein a non-repetitive type symbol sequence 9 is processed. In said substate S1.3, a predetermined number of data symbols 6 are read into the input packet buffer 2.1. Each data symbol 6 is compared with its successor. Once a repetition of a data symbol 6 is encountered, indicating that the non-repetitive type symbol sequence 9 ends, condition C3b is fulfilled. Then the substate S1.3 is left and the substate S1.4 is entered, wherein the reduced symbol sequence 11 corresponding to the just completed non-repetitive type symbol sequence 9 is formed.

If the input packet buffer 2.1 was completely processed before the end of the non-repetitive type symbol sequence 9 was detected, the next segment 1.1 is read in from the unencoded input stream 1 into the input packet buffer 2.1. This is denoted by the condition/action type state transition CA1.

In the substate S1.4, the control symbol 7a, 7b encoding the length and type of the non-repetitive type symbol sequence 9 is written to the output packet buffer of the encoder, followed by all data symbols 6 of the reduced symbol sequence 11. If said output packet buffer was completely filled, it is flushed to the encoded output stream 3, and the writing of the reduced symbol sequence 11 is resumed. This is indicated by the condition/action type state transition CA2.

The substates S1.1 and S1.3 may be reached not just from the start state S0, but also from the substates S1.4 and S1.2, respectively, if further data symbols 6 are read in from the unencoded input stream 1. If the end of the unencoded input stream 1 is reached, i.e. if the condition C4 is fulfilled, the encoding process ends, thus leaving the encoding state S1 and entering the end state S3.

If the length of a symbol sequence 8a, 8b, 9, 8c exceeds a predetermined limit, as for example 127 symbols, indicated by the condition C5, such a symbol sequence is split and treated as a plurality of independent symbol sequence 8a, 8b, 9, 8c with each of them being within the predetermined limit. Thus, a transition of the substates S1.2, S1.4 towards the substates S1.1, S1.3, respectively, is possible under said condition C5 is possible.

It is possible to treat further conditions, as for example an incomplete or empty unencoded input stream 1, as an error condition CErr that will result in a transition towards the end state S3 from an arbitrary substate S1.1, S1.2, S1.3, S1.4 within the encoding state S1.

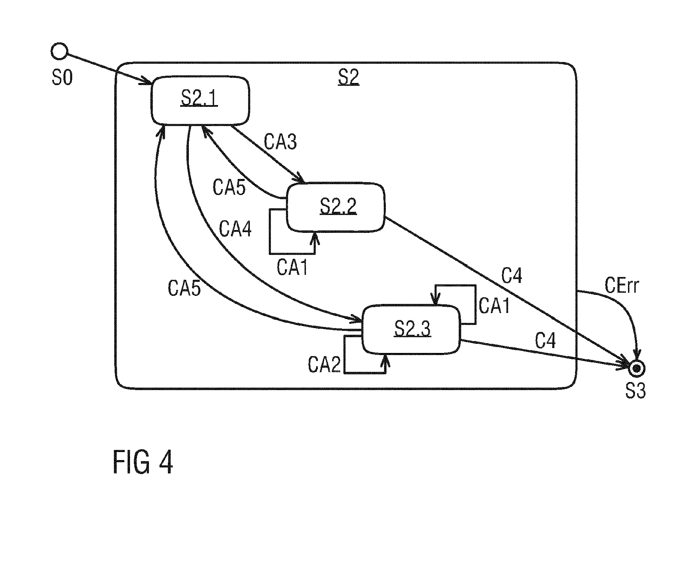

**Figure 4** shows a state diagram for the decoding method. The decoding process summarized in the decoding status S2 starts from a start state S0.

Then the substate S2.1 is entered, wherein a control symbol 7a, 7b is read and decoded from an encoded input stream 3, so that the type and the length of the symbol sequence 8a, 8b, 9, 8c corresponding to the reduced symbol sequence 10a, 10b, 11, 10c that immediately follows said control symbol 7a, 7b is determined.

If the control symbol 7a encodes a repetitive type symbol sequence 8a, 8b, 8c, the substate S2.2 is entered, wherein a reduced symbol sequence 10a, 10b, 10c corresponding to a repetitive type symbol sequence 8a, 8b, 8c is expanded. The single data symbol 6 and its at least one repetitions are written to the output packet buffer 4.1 of the decoder 4. The input packet buffer is refilled if it did not fully comprise the reduced symbol sequence 10a, 10b, 10c, as indicated by the condition/action CA1.

If the repetitive type symbol sequence 8a, 8b, 8c was completely written, the next control symbol 7a, 7b is retrieved from the encoded input stream 3, as indicated by the condition/action CA5. If the output packet buffer 4.1 is full before the repetitive type symbol sequence 8a, 8b, 8c could be completed, this is considered an error condition CErr and a transition towards the end state S3 is performed.

If the control symbol 7a, 7b encodes a non-repetitive type symbol sequence 9, the substate S2.3 is entered, wherein a reduced symbol sequence 11 corresponding to a non-repetitive type symbol sequence 9 is expanded. The number of data symbols 6 corresponding to the symbol sequence length encoded by the control symbol 7a, 7b is retrieved from the input packet buffer and copied to the output packet buffer 4.1 of the decoder 4. The input packet buffer is refilled if it did not fully comprise the reduced symbol sequence 11, as indicated by the condition/action CA1. If the output packet buffer is filled before the non-repetitive type symbol sequence 11 could be completed, this is considered as an error condition CErr and a transition towards the end state S3 is performed. If the non-repetitive type symbol sequence 11 was completely written, the next control symbol 7a, 7b is retrieved from the encoded input stream 3, as indicated by the condition/action CA5.

If the end of the encoded input stream 3 is reached, i.e. if the condition C4 is fulfilled, the decoding process ends, thus leaving the decoding state S2 and entering the end state S3.

It is possible to treat further conditions, as for example an incomplete or an empty encoded input stream 3, as an error condition CErr that will result in a transition towards the end state S3 from an arbitrary substate S2.1, S2.2, S2.3 within the decoding state S2.

### List of References

- 1: unencoded input stream
- 1.1: segment
- 2: encoder
- 2.1: input packet buffer
- 2.1.1: memory cell
- 2.2: status buffer
- 3: encoded stream
- 4: decoder
- 4.1: output packet buffer
- 4.2: status buffer
- 4.2.1: memory cell
- 5: decoded output stream
- 5.1: segment
- 6: data symbol
- 7a, 7b: control symbol
- 8a, 8b, 8c: repetitive type symbol sequence
- 9: non-repetitive type symbol sequence
- 10a, 10b, 10c: reduced symbol sequence
- 11: reduced symbol sequence
- S0: start state
- S1: encoding state
- S1.1: substate: counting repeated data symbols
- S1.2: substate: writing reduced symbol sequence of repetitive type symbol sequence
- S1.3: substate: counting non-repeating data symbols
- S1.4: substate: writing reduced symbol sequence of non-repetitive type symbol sequence
- S2: decoding state
- S2.1: substate: decoding control symbol
- S2.2: substate: expanding reduced symbol sequence of repetitive type symbol sequence
- S2.3: substate: expanding reduced symbol sequence of non-repetitive type symbol sequence
- S3: end state
- C1: condition: current data symbol identical to subsequent data symbol
- C2: condition: current data symbol differs from subsequent data symbol
- C3a: condition: end of data symbol repetition
- C3b: condition: begin of data symbol repetition
- CErr: condition: an error was detected
- C4: condition: end of input stream
- C5: condition: length of symbol sequence exceeds predetermined limit
- CA1: condition: input packet buffer empty / action refill input packet buffer
- CA2: condition: output packet buffer full / action flush output packet buffer
- CA3: condition: control symbol indicates repetitive type symbol sequence / action retrieve data symbol
- CA4: condition: control symbol indicates non-repetitive type symbol sequence / action retrieve reduced symbol sequence
- CA5: condition: symbol sequence completed / action retrieve next control symbol

## Claims

1. A method for processing a data stream (1, 3), comprising an encoding and a decoding method, the encoding method comprising the iteratively repeated steps:
- reading a symbol sequence (8a, 8b, 8c, 9) consisting of either a repetition of a data symbol (6) or consisting of at least one non-repetitive data symbol (6) from an unencoded input stream (1),
- determining the symbol sequence length,
- writing a control symbol (7a, 7b) encoding the symbol sequence length and a reduced symbol sequence (10a, 10b, 11, 10c) with repetitions of a data symbol (6) removed to an encoded stream (3) and the decoding method comprising the iteratively repeated steps:
- reading the control symbol (7a, 7b) encoding the symbol sequence length from an encoded stream (3),
- reading the reduced symbol sequence (10a, 10b, 11, 10c) from an encoded stream (3),
- expanding the reduced symbol sequence (10a, 10b, 11, 10c) into the symbol sequence (8a, 8b, 8c, 9) by optionally appending repetitions of a single data symbol (6) contained in the reduced symbol sequence(10a, 10b, 10c),
- writing the symbol sequence (8a, 8b, 8c, 9) to an decoded output stream (5),
**characterized in that** repeatedly at most a first number of symbols is transferred from the data stream (1) into an input packet buffer (2.1) and/or at most a second number of symbols is transferred from an output packet buffer (4.1) to a decoded output stream (5) and further **characterized in that** a status buffer (2.2) is updated with every transfer operation.

2. A method according to claim 1 **characterized in that** the status buffer (2.2) comprises data structures to store information on
- the type of the symbol sequence (8a, 8b, 8c, 9) or reduced symbol sequence (10a, 10b, 11, 10c),
- the completion status of the symbol sequence (8a, 8b, 8c, 9) or reduced symbol sequence (10a, 10b, 11, 10c),
- optionally, the number of data symbols (6) of the symbol sequence (8a, 8b, 8c, 9) already read from an unencoded input stream (1),
- optionally, the number of data symbols (6) of the reduced symbol sequence (10a, 10b, 11, 10c) to be read from an input stream (1, 3) or the number of data symbols (6) written to an output stream (3, 5).

3. A method according to one of the previous claims **characterized in that** a data symbol (6) is formed as a single byte or three bytes or an array of a predetermined number of bytes.

4. A method according to one of the previous claims **characterized in that** a data symbol (6) represents a pixel of a digitized image.

5. A method according to one of the previous claims **characterized in that** the symbol sequence length is encoded in a control symbol (7a, 7b) with a predetermined length, wherein the bit representation of the control symbol (7a, 7b) equals the symbol sequence length for non-repetitive type symbol sequences (8a, 8b, 8c) and wherein the bit representation of the control symbol (7a, 7b) equals the symbol sequence length plus a predetermined offset value for repetitive type symbol sequences (9).

6. An apparatus for encoding and/or decoding a data stream (1,3), comprising an encoder (2) and a decoder (4) iteratively performing the following steps for encoding an unencoded input stream (1):
- reading a symbol sequence (8a, 8b, 8c, 9) consisting of either a repetition of a data symbol (6) or consisting of at least one non-repetitive symbol from the unencoded input stream (1),
- determining the symbol sequence length,
- writing a control symbol (7a, 7b) encoding the symbol sequence length and a reduced symbol sequence (10a, 10b, 11, 10c) with repetitions of a data symbol (6) removed to an encoded stream (3) and/or iteratively performing the following steps for decoding an encoded stream (3):
- reading a control symbol (7a, 7b) encoding the symbol sequence length from an encoded stream (3),
- reading the reduced symbol sequence (10a, 10b, 11, 10c) from an encoded stream (3),
- expanding the reduced symbol sequence (10a, 10b, 11, 10c) to the symbol sequence (8a, 8b, 8c, 9) by optionally appending repetitions of a single data symbol (6) contained in the reduced symbol sequence (10a, 10b, 11, 10c),
- writing the symbol sequence (8a, 8b, 8c, 9) to a decoded output stream (5)
and further comprising an input packet buffer (2.1) and/or an output packet buffer (4.1) and a status buffer (2.2, 4.2), wherein at most a first number of symbols is transferred from an input stream (1, 3) into the input packet buffer (2.1) and/or at most a second number of symbols is transferred from the output packet buffer (4.1) to an output stream (3, 5) and wherein the status buffer (2.2, 4.2) is updated with every transfer.
